(19) Europäisches Patentamt
European Patent Office
Office européen des brevets

(11) **EP 3 961 929 A1**

(12) **EUROPEAN PATENT APPLICATION**
published in accordance with Art. 153(4) EPC

(43) Date of publication:
**02.03.2022 Bulletin 2022/09**

(21) Application number: **19929855.5**

(22) Date of filing: **23.05.2019**

(51) International Patent Classification (IPC):
**H03L 7/08** (2006.01)    **H03L 7/089** (2006.01)
**H03L 7/18** (2006.01)

(52) Cooperative Patent Classification (CPC):
**H03L 7/08;** H03L 7/089; H03L 7/18

(86) International application number:
**PCT/CN2019/088214**

(87) International publication number:
**WO 2020/232726 (26.11.2020 Gazette 2020/48)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Huawei Technologies Co., Ltd.
Shenzhen, Guangdong 518129 (CN)**

(72) Inventors:
• **LI, Wei
Shenzhen, Guangdong 518129 (CN)**
• **ZHOU, Weiyi
Shenzhen, Guangdong 518129 (CN)**
• **ZHOU, Shenghua
Shenzhen, Guangdong 518129 (CN)**

(74) Representative: **Thun, Clemens
Mitscherlich PartmbB
Patent- und Rechtsanwälte
Sonnenstraße 33
80331 München (DE)**

(54) **PHASE LOCKED LOOP**

(57) This application discloses a phase-locked loop, and relates to the field of chip technologies. This can resolve problems of high power consumption, loud noise, and a complex charge pump circuit structure due to a non-ideal feature of a charge pump. The phase-locked loop includes a charge pump, and the charge pump includes a pair of current sources and two differential paths. The charge pump further includes a first switch transistor and a second switch transistor, and the first switch transistor and the second switch transistor are respectively disposed on the two differential paths. The charge pump further includes a first auxiliary transistor and a second auxiliary transistor. A gate of the first auxiliary transistor is coupled to a gate of the first switch transistor, and a gate of the second auxiliary transistor is coupled to a gate of the second switch transistor; a first terminal of the first auxiliary transistor is coupled to a first current source, and a second terminal of the first auxiliary transistor is coupled to a second terminal of the second switch transistor; and a first terminal of the second auxiliary transistor is coupled to the first current source, and the second terminal of the first auxiliary transistor is coupled to a second terminal of the first switch transistor. Embodiments of this application are used to suppress the non-ideal factor of the charge pump.

FIG. 10

**Description**

**TECHNICAL FIELD**

This application relates to the field of chip technologies, and in particular, to a phase-locked loop.

**BACKGROUND**

A spurious tone (spurious tone) is a key factor in jitter (jitter) and spur (spur) performance. In various spur sources in a phase-locked loop (Phase-Locked Loop, PLL) system, in addition to spurs caused by a power supply, the ground, and the like, most spurs are caused by a non-ideal factor of a charge pump, and performance of an entire PLL directly depends on quality of the charge pump.

Currently, there are mainly four non-ideal factors of a charge pump: clock feedthrough (clock feedthrough), charge injection (charge injection), direct current mismatch (Direct Current mismatch, DC mismatch), and charge sharing (charge sharing). For the non-ideal factors, there are a plurality of charge pump structures used to cancel specific non-ideal factors. All charge pump circuit structures may be divided into two types: a single-charge pump structure and a multi-charge pump structure. The single-charge pump structure can cancel specific non-ideal factors by adding an operational amplifier or a feedback path. The multi-charge pump structure can cancel the non-ideal factors by superimposing different charge pump features. For example, the single-charge pump structure may be a current-steering charge pump (Current-Steering Charge Pump), a charge pump with a servo loop (Charge Pump with a Servo Loop), or a charge pump with a spur detection and feedback compensation circuit.

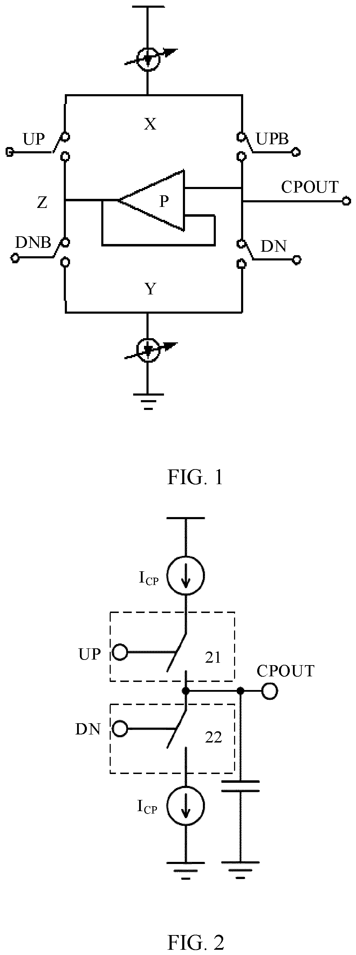

The current-steering charge pump is used as an example. A diagram of a principle of the current-steering charge pump may be shown in FIG. 1. FIG. 1 shows a drain-based switch structure, including four switches, namely, UP, UPB, DNB, and DN, and a unity gain buffer (unity gain buffer) P. The four switches may be MOS transistors. In the drain-based switch structure in a charge pump structure, the current-steering charge pump is formed by adding the switch UPB and the switch DNB that are controlled by one path of two signals with opposite phases, and the unity gain buffer P. The unity gain buffer is configured to track a potential of a charge pump output (CPOUT), so that potentials at points X, Y, and Z are consistent with the potential of CPOUT. To be specific, the four switches may be on or off in any sequence, to ensure the potentials at points X, Y, and Z are consistent with the potential of the output voltage CPOUT by using the unity gain buffer. This eliminates a charging/discharging problem of a parasitic capacitance of the MOS transistor as a switch, and resolves non-ideal features of charge sharing and charge injection to some extent. However, this cannot effectively resolve clock feedthrough and direct current mismatch, and cancels limited spurs. Because the unity gain buffer is added to a circuit in the structure, extra power consumption is cost and extra noise is introduced.

**SUMMARY**

Embodiments of this application provide a phase-locked loop. This can resolve problems of high power consumption, loud noise, and a complex charge pump circuit structure due to a non-ideal feature of a charge pump.

According to a first aspect, a PLL is provided, including a charge pump. The charge pump includes a pair of current sources and two differential paths, the charge pump further includes a plurality of pairs of switch transistors, each pair of switch transistors are respectively disposed on the two differential paths, and the charge pump further includes an auxiliary transistor in a one-to-one correspondence with the switch transistor. A pair of switch transistor is used as an example. For example, the charge pump includes a first switch transistor and a second switch transistor, and the first switch transistor and the second switch transistor are respectively disposed on the two differential paths. The charge pump further includes a first auxiliary transistor and a second auxiliary transistor. A gate of the first auxiliary transistor is coupled to a gate of the first switch transistor, and a gate of the second auxiliary transistor is coupled to a gate of the second switch transistor; a first terminal of the first switch transistor is coupled to a first current source, and a second terminal of the first switch transistor is coupled to a second current source; a first terminal of the second switch transistor is coupled to the first current source, and a second terminal of the second switch transistor is coupled to the second current source; a first terminal of the first auxiliary transistor is coupled to the first current source, and a second terminal of the first auxiliary transistor is coupled to the second terminal of the second switch transistor; and a first terminal of the second auxiliary transistor is coupled to the first current source, and a second terminal of the second auxiliary transistor is coupled to the second terminal of the first switch transistor.

The first switch transistor, the second switch transistor, the first auxiliary transistor, and the second auxiliary transistor may all be PMOS transistors or NMOS transistors. Each transistor in the switch transistor or the auxiliary transistor includes a source and a drain. When one of the source and the drain is a first terminal, the other is a second terminal. In this way, for each pair of switch transistors, a circuit design may be: sources of two auxiliary transistors respectively corresponding to each pair of switch transistors are connected to each other, a gate of each auxiliary transistor is connected to a gate of a corresponding switch transistor, and a drain of each auxiliary transistor is connected to a drain of a peer switch transistor of a corresponding switch transistor. A specific implementation of this application is also described by using the circuit design. Because the gate of the auxiliary transistor is connected to the gate of the corresponding switch transistor, when a gate voltage of the switch transistor changes, a voltage of the corresponding auxiliary transistor also changes. A drain voltage of the auxiliary transistor varies with a gate voltage of the auxiliary transistor. In a case in which differential switch signals of the two differential paths are complementary, at a switching moment, a current glitch generated by the drain of the auxiliary transistor and a current glitch generated by the drain of the peer switch transistor of the corresponding switch transistor are close in size and opposite in phase. In this case, the auxiliary transistor may be used to cancel the current glitch generated by the drain of the peer switch transistor at the switching moment. In this application, the auxiliary transistor is added, so that the circuit design is simple, and no extra power consumption is generated.

In a possible design, differential voltages are separately input to gates of each pair of switch transistors. For example, differential voltages are separately input to gates of the first switch transistor and the second switch transistor. It is assumed that the plurality of pairs of switch transistors are two pairs of switch transistors, the two pairs of switch transistors include a switch pair including the first switch transistor and the second switch transistor, and a switch pair including a third switch transistor and a fourth switch transistor. The two differential paths include a first differential path and a second differential path, the first differential path includes the first switch transistor and the third switch transistor, and the second differential path includes the second switch transistor and the fourth switch transistor; and auxiliary transistors that are in a one-to-one correspondence with the two pairs of switch transistors include the first auxiliary transistor, the second auxiliary transistor, a third auxiliary transistor, and a fourth auxiliary transistor. The first switch transistor corresponds to the first auxiliary transistor, the second switch transistor corresponds to the second auxiliary transistor, the third switch transistor corresponds to the third auxiliary transistor, and the fourth switch transistor corresponds to the fourth auxiliary transistor. The first current source includes a first transistor, and the second current source includes a second transistor. In other words, when each of the two differential paths of the charge pump includes two switch transistors, each switch transistor corresponds to an auxiliary transistor, and the auxiliary transistor is configured to cancel a current glitch generated at a switching moment of a peer switch transistor of each switch transistor.

In a possible design, a source of the first switch transistor is connected to a source of the second switch transistor, and both the source of the first switch transistor and the source of the second switch transistor are connected to a drain of the first transistor. A source of the third switch transistor is connected to a source of the fourth switch transistor, and both the source of the third switch transistor and the source of the fourth switch transistor are connected to a drain of the second transistor. A drain of the first switch transistor is connected to a drain of the third switch transistor, and a drain of the second switch transistor is connected to a drain of the fourth switch transistor. The gate of the first switch transistor is connected to the gate of the first auxiliary transistor, and the gate of the second switch transistor is connected to the gate of the second auxiliary transistor. A gate of the third switch transistor is connected to a gate of the third auxiliary transistor, and a gate of the fourth switch transistor is connected to a gate of the fourth auxiliary transistor. A source of the first auxiliary transistor is connected to a source of the second auxiliary transistor, and a source of the third auxiliary transistor is connected to a source of the fourth auxiliary transistor. A drain of the first auxiliary transistor is connected to the drain of the second switch transistor, a drain of the second auxiliary transistor is connected to the drain of the first switch transistor, a drain of the third auxiliary transistor is connected to the drain of the fourth switch transistor, and a drain of the fourth auxiliary transistor is connected to the drain of the second auxiliary transistor.

In a possible design, when the first switch transistor is off, and the second switch transistor is on, or when the first switch transistor is on, and the second switch transistor is off, a gate voltage of the first auxiliary transistor varies with a gate voltage of the first switch transistor, and a gate voltage of the second auxiliary transistor varies with a gate voltage of the second switch transistor; a first pulse current is generated at the second terminal of the first switch transistor, and a second pulse current is generated at the second terminal of the second auxiliary transistor, where the first pulse current and the second pulse current are equal in size and opposite in direction; and a third pulse current is generated at the second terminal of the second switch transistor, a fourth pulse current is generated at the second terminal of the first auxiliary transistor, where the third pulse current and the fourth pulse current are equal in size and opposite in direction. When pulse currents are equal in size and opposite in direction, the auxiliary transistor may be used to cancel a current glitch generated at a moment when the switch is off or on, reduce a net charge output by a CPOUT node, and reduce a spur introduced to a PLL system.

In a possible design, the charge pump includes an output node disposed between the two switch transistors on one of the two differential paths, the charge pump further includes a self-biased circuit, and the self-biased circuit is configured to adjust a voltage of a node between the two switch transistors on the other differential path of the two differential paths based on a voltage of the output node. The node between the two switch transistors may be a node between drains of the two switch transistors. The self-biased circuit may provide a bias point, so that a current of the self-biased circuit varies with the voltage of the output node in the charge pump. A voltage reflects a change of the current, so that a voltage of the bias point varies with the voltage of the output node in the charge pump. This can minimize mismatch of a charge pump circuit.

In a possible design, the self-biased circuit enables the voltage of the node between the two switch transistors on the other differential path to vary with the voltage of the output node. For example, when the voltage of the node between the two switch transistors is equal to the voltage of the output node, a change of the voltage of the bias point may be consistent with a change of the voltage of the output node in the charge pump. This ensures minimum mismatch of the charge pump circuit, and reduces a charge sharing effect.

In a possible design, the self-biased circuit includes a first bias transistor connected to the output node, a plurality of bias transistors that form current mirror structures with the pair of current sources, and a second bias transistor connected to the current mirror structure. The current mirror structure can replace a unity gain buffer or the like in a conventional technology. This reduces power consumption and a layout area.

In a possible design, the first current source includes a first transistor, and the second current source includes a second transistor; the bias transistor that forms a current mirror structure with the second transistor includes a third bias transistor, a fourth bias transistor, and a fifth bias transistor; and the bias transistor that forms a current mirror structure with the first transistor includes a sixth bias transistor. When a size of the bias transistor that forms a current mirror structure is well-adjusted, a current of the bias transistor that forms a current mirror structure can have good followability. In this way, when the voltage of the output node changes, the current of the current mirror reflects a change of the voltage. Therefore, the current of the self-biased circuit may vary with the voltage of the output node, the voltage of the node between the drains of the two switch transistors on the differential path varies with the current of the self-biased circuit, and the voltage of the node between the drains of the two switch transistors on the other differential path is equal to the voltage of the output node.

In a possible design, a gate of the first bias transistor is coupled to the output node, a first terminal of the first bias transistor is coupled to the first current source, and a second terminal of the first bias transistor is coupled to a first terminal of the third bias transistor; a gate of the third bias transistor is coupled to a gate of the second transistor, a second terminal of the third bias transistor is coupled to a first terminal of the second transistor, and the gate of the third bias transistor is coupled to the second terminal of the third bias transistor; a gate of the fourth bias transistor is coupled to a gate of the second current source, a first terminal of the fourth bias transistor is coupled to the first terminal of the second transistor, and a second terminal of the fourth bias transistor is coupled to a second terminal of the sixth bias transistor; a gate of the fifth bias transistor is coupled to the gate of the fourth bias transistor, a first terminal of the fifth bias transistor is coupled to the first terminal of the second transistor, and a second terminal of the fifth bias transistor is coupled to a second terminal of the second transistor; a gate of the sixth bias transistor is coupled to a gate of the first transistor, a first terminal of the sixth bias transistor is coupled to a first terminal of the first transistor, and the gate of the sixth bias transistor is coupled to a second terminal of the sixth bias transistor; a first terminal of the second bias transistor is coupled to the first terminal of the first transistor, and a gate of the second bias transistor is coupled to a second terminal of the second bias transistor; and a node between the second terminal of the second bias transistor and the second terminal of the fifth bias transistor is coupled to a node between the switch transistors on the other differential path.

In a possible design, when the voltage of the output node increases, a gate voltage of the first bias transistor decreases, a current of the first bias transistor decreases, a current of the second transistor and a current of the bias transistor that forms a current mirror structure with the second transistor decrease, a current of the bias transistor that forms a current mirror structure with the first transistor decreases, a voltage of the node between the second terminal of the second bias transistor and the second terminal of the fifth bias transistor increases, and the voltage of the node between the two switch transistors on the other differential path increases; or when the voltage of the output node decreases, a gate voltage of the first bias transistor increases, a current of the first bias transistor increases, a current of the second transistor and a current of the bias transistor that forms a current mirror structure with the second transistor increase, a current of the first transistor and a current of the bias transistor that forms a current mirror structure with the first transistor increase, a voltage of the node between the second terminal of the second bias transistor and the second terminal of the fifth bias transistor decreases, and the voltage of the node between the two switch transistors on the other differential path decreases. Therefore, the self-biased circuit provided in this application may be used to achieve an adaptive bias effect, and reduce a requirement for an extra bias circuit. In addition, relatively small power consumption is required, and a layout area is compact. Because there is no extra complex system such as an operational amplifier and a glitch detection circuit, a response speed is fast, and the charge pump may be used in a high-speed system. In addition, the charge pump in this application may be widely adaptable, and can be placed in a plurality of different PLL systems. Because a structure of the charge pump is simple, the charge pump in this application is very reliable in different CMOS processes.

In a possible design, at least one of the two current sources includes cascode structures of at least two stages. Based on a definition of the current source, when the current source has infinite internal resistance, a current output by the current source remains unchanged and does not vary with an external circuit of the current source. In this case, when the current source in this application uses a cascode structure, output impedance of the current source may be multiplied, so that the current source tends to be an ideal current source, and outputs a constant current. This further reduces mismatch between an upper current source and a lower current source in the charge pump.

In a possible design, the PLL further includes a phase frequency detector PFD, a loop filter LPF, a voltage-controlled oscillator VCO, and a frequency divider. The PFD is configured to perform discrete-time sampling on a phase difference between an input reference frequency and a frequency fed back by the frequency divider, to obtain a discrete-time phase difference signal. The LPF is configured to integrate and hold a discrete-time charge signal output by the charge pump, to output a voltage signal. The VCO is configured to obtain an expected signal frequency and an expected phase based on the voltage signal output by the LPF. The frequency divider includes an input divider, an output divider, and a feedback frequency divider, where the input divider is configured to: divide the input reference frequency, and input a divided frequency to the PFD, the output divider is configured to divide and output the frequency of the VCO, and the feedback frequency divider is configured to: divide the feedback frequency, and input a divided frequency to the PFD. A first terminal of the PFD is coupled to a first terminal of the charge pump; a second terminal of the charge pump is coupled to the first terminal of the LPF; a second terminal of the LPF is coupled to a first terminal of the VCO; a second terminal of the VCO is coupled to a first terminal of the frequency divider; and a node between the second terminal of the VCO and the frequency divider is coupled to a second terminal of the PFD.

According to a second aspect, a PLL is provided, including a phase frequency detector PFD, a charge pump, a loop filter LPF, a voltage-controlled oscillator VCO, and a frequency divider, where the charge pump includes two differential paths and a self-biased circuit, the self-biased circuit is configured to adjust, based on a voltage of an output node between two switch transistors on one differential path, a voltage of node between two switch transistors on the other differential path.

In a possible design, the self-biased circuit enables the voltage of the node between the two switch transistors on the other differential path to vary with the voltage of the output node.

According to a third aspect, a communication device is provided. The communication device includes the PLL in the first aspect or the PLL in the second aspect.

Therefore, a glitch cancellation circuit in this application is configured to reduce a glitch or a narrow pulse generated at a switching moment of the switch in the charge pump. This reduces impact of clock feedthrough and charge injection on the circuit. An adaptive bias circuit in this application can provide the bias point for the charge pump circuit, so that voltages of nodes connected to switch transistors in the charge pump circuit are consistent. This reduces the charge sharing effect, and reduces DC current mismatch between the upper current source and the lower current source. The charge pump circuit in this application has a simple structure with small power consumption and a small layout area.

**BRIEF DESCRIPTION OF DRAWINGS**

FIG. 1 is a schematic diagram of a principle of a current-steering charge pump;
FIG. 2 is a schematic diagram of a structure of an ideal charge pump according to an embodiment of this application;
FIG. 3 is a schematic diagram of a principle of clock feedthrough of a MOS transistor according to an embodiment of this application;
FIG. 4 is a schematic diagram of a principle of charge injection according to an embodiment of this application;
FIG. 5 is a schematic diagram of a principle of DC current mismatch according to an embodiment of this application;
FIG. 6 is a schematic diagram of an architecture of a PLL system according to an embodiment of this application;
FIG. 7 is a schematic diagram of a structure of a typical charge pump according to an embodiment of this application;
FIG. 8(a), FIG. 8(b), and FIG. 8(c) are schematic diagrams of three working states of a charge pump according to an embodiment of this application;
FIG. 9 is a schematic diagram of a principle of a charge pump according to an embodiment of this application;
FIG. 10 is a schematic diagram of a principle of a charge pump to which an auxiliary transistor is added according to an embodiment of this application;
FIG. 11 is a schematic diagram of a simulation result of a glitch cancellation circuit in a charge pump according to an embodiment of this application;
FIG. 12 is a schematic diagram of a structure of a self-biased circuit in a charge pump according to an embodiment of this application;
FIG. 13 is a schematic diagram of a simulation result of a self-biased circuit in a charge pump according to an embodiment of this application;
FIG. 14 is a schematic diagram of a structure of a charge pump according to an embodiment of this application;
FIG. 15 is a schematic diagram of a structure of a charge pump with a cascode structure according to an embodiment of this application;
FIG. 16 is a schematic diagram of a structure of a chip according to an embodiment of this application; and

FIG. 17 is a schematic diagram of a structure of a communication device according to an embodiment of this application.

## DESCRIPTION OF EMBODIMENTS

For ease of understanding, example description of some concepts related to this application is provided for reference are shown as follows:

PLL system: The PLL system is essentially a discrete-time system. A feature of the PLL system is controlling a frequency and a phase of an oscillation signal inside a loop of the PLL system by using a reference signal input from the outside of the PLL system.

Charge pump (charge pump, CP): In the PLL system, the charge pump is configured to convert a discrete-time phase signal into a discrete-time charge signal, or is mainly configured to convert a digital signal output by a phase frequency detector in the PLL system into an analog signal, to control an oscillation frequency of a voltage-controlled oscillator in the PLL system. When the loop of the PLL system is locked at a frequency, an output voltage of the charge pump CPOUT remains at a fixed voltage. A structure of a common charge pump is shown in FIG. 2, and includes two current sources ($I_{CP}$) with switches (a switch 21 on an UP branch and a switch 22 on a DN branch), where a MOS transistor is usually used as a switch.

A design of the charge pump is of great importance to performance of the PLL system. The following describes problems caused by design disadvantages of the charge pump.

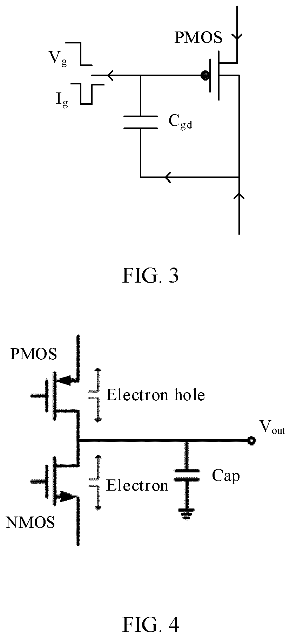

Clock feedthrough: In a circuit, parasitic capacitances exist in each MOS transistor. The charge pump includes a plurality of switch transistors that use MOS transistors as switches. Therefore, as shown in FIG. 3, one PMOS transistor in the charge pump is used as an example, and parasitic capacitances $C_{gd}$ exist between a gate and a drain of the PMOS transistor. When a gate voltage of the PMOS transistor changes, a drain voltage changes accordingly, and a quantity of charges stored in one plate inside a capacitor $C_{gd}$ changes. To achieve charge balance, electrons whose quantity is equal to the quantity of charges need to be injected near another plate. According to a formula i(t) = C x dv/dt, C indicates a change amount of charges in the capacitor $C_{gd}$, dv indicates a change amount of voltages of the capacitor $C_{gd}$, and dt indicates a change amount of time. In this case, a current with a value of i(t) flows through the capacitor $C_{gd}$, and a narrow pulse current is generated at the drain of the PMOS transistor. In other words, when the gate voltage of the PMOS transistor changes dynamically, a non-ideal narrow pulse current is generated at the drain of the PMOS transistor due to the parasitic capacitances. Because in the PLL system, an output terminal of the charge pump is connected to the loop filter, if the narrow pulse current is injected into the loop filter, a non-ideal spur is introduced to the loop.

Charge injection: As shown in FIG. 4, for the MOS transistor in the charge pump, a free electron (electron hole) exists in a channel (channel) of the MOS transistor. When a gate voltage of the MOS transistor in the charge pump changes, an upper plate attracts an extra electron. Consequently, a current is injected into or outflows the channel, and a narrow pulse current is generated at the drain. If the pulse current is injected into the loop filter, a non-ideal spur is introduced to the loop.

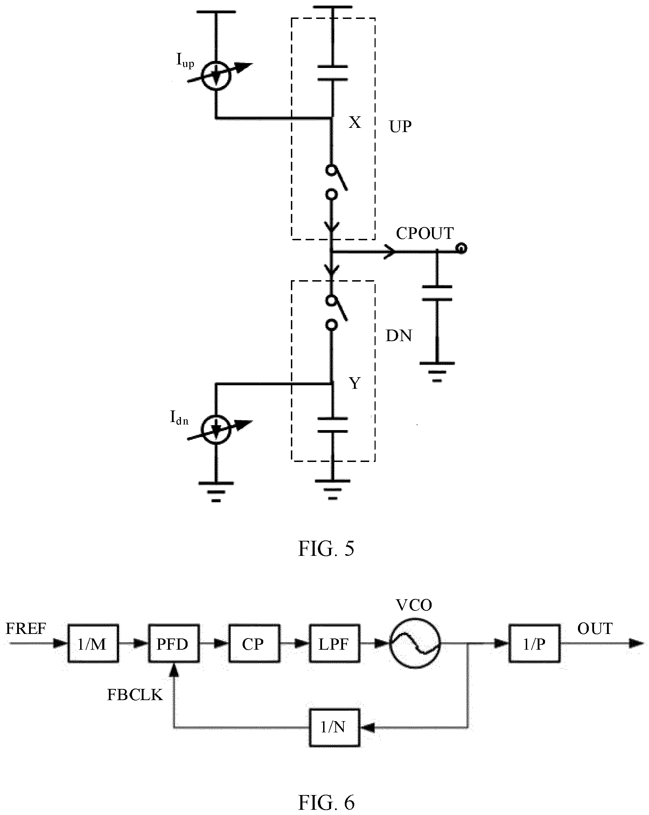

DC current mismatch: In a circuit structure of the charge pump, as shown in FIG. 5, each of the UP branch and the DN branch in the charge pump has a current source to provide DC currents, including a pull-up current $I_{up}$ and a pull-down current $I_{dn}$, and conduction of the current source is controlled by the switch. Ideally, the pull-up current $I_{up}$ is equal to the pull-down current $I_{dn}$, so that no net charge is injected into the loop filter. Usually, the switch is implemented by a PMOS transistor or an NMOS transistor. A feature of the PMOS is not completely consistent with a feature of the NMOS due to channel length modulation of the MOS transistor. Therefore, when different types of MOS transistors are used on two paths, and output voltages of the charge pump are different, the pull-up current $I_{up}$ and the pull-down current $I_{dn}$ do not match, and a current difference exists, that is, current mismatch exists between the upper current source and the lower current source. The generated current difference causes net charge injection in the loop filter. If the current generated by the DC current mismatch is injected into the loop filter, a capacitor in the loop filter is charged and discharged. This causes a voltage ripple, and introduces a spur and jitter in the loop filter. Charge sharing: As shown in FIG. 5, there are three nodes, namely, X, Y, and CPOUT, in the charge pump circuit, and each node has an equivalent capacitance to ground. When switches in the UP branch and the DN branch are off, the three nodes are independent. The capacitance to ground of each node stores a specific quantity of charges, so that voltages, namely, $V_x$, $V_y$, and $V_{cpout}$, of the nodes are relatively independent. If initial voltages between nodes are different, charges stored in corresponding capacitances are also different. When the switches in the UP branch and the DN branch are on, the three nodes are connected. In this case, the charges stored in the capacitances of the three nodes are redistributed to achieve new balance and obtain a new voltage of the node. This process is referred to as charge sharing. During capacitance redistribution, movement of the charges causes a spur and jitter in the circuit.

This application may be applied to the PLL system. For a spur introduced to the PLL system by a non-ideal feature of the charge pump in the PLL system, the circuit structure of the charge pump designed in this application can suppress non-ideal features such as a spur and noise in the charge pump circuit. In addition, a circuit system is not complex and power consumption is low.

FIG. 6 is a schematic diagram of an architecture of a PLL system. The PLL system may include a phase frequency detector (Phase Frequency Detector, PFD), a charge pump (Charge Pump, CP), a loop filter (Loop Filter, LPF), a voltage-controlled oscillator (Voltage-Controlled Oscillator, VCO), a frequency divider, and the like. The charge pump plays a key role in discrete-phase sampling and discrete-time charge signal conversion, and performance of the charge pump directly affects performance of the entire PLL system to reduce phase noise and cancel a spur (spur).

The PFD is configured to perform discrete-time sampling on a phase difference between an input reference frequency and a frequency fed back by the frequency divider, to obtain a discrete-time phase difference signal, namely, a phase frequency detection result, and input the phase frequency detection result to the charge pump.

The charge pump is configured to convert the discrete-time phase difference signal obtained through sampling by PFD into a discrete-time charge signal.

The LPF is configured to integrate and hold, namely, filter, the discrete-time charge signal output by the CP, to output a voltage signal.

The VCO is configured to obtain an expected signal frequency and an expected phase based on the voltage signal output by the LPF.

The frequency divider includes an input divider 1/M, an output divider 1/P, and a feedback frequency divider 1/N, where the input divider 1/M is configured to: divide the input reference frequency, and input a divided frequency to the PFD, the output divider 1/P is configured to divide and output the frequency of the VCO, and the feedback frequency divider 1/N is configured to: divide the feedback frequency, and input a divided frequency to the PFD.

As shown in FIG. 6, an output terminal of the input divider 1/M is connected to a first input terminal of the PFD, an output terminal of the PFD is connected to an input terminal of the CP, an output terminal of the CP is connected to an input terminal of the LPF, an output terminal of the LPF is connected to an input terminal of the VCO, an output terminal of the VCO is connected to an input terminal of the output divider, the output terminal of the VCO is further connected to an input terminal of the feedback frequency divider, and an output terminal of the feedback frequency divider is connected to a second input terminal of the PFD.

The PLL system can be applied to technologies such as a clock tree and a frequency synthesizer. For example, in the clock tree technology, for either a synchronous circuit or an asynchronous circuit, stable clock signals are needed in transmitting, operating, and storing digital information of a digital circuit clock, and the PLL system may be used to generate a stable clock signal. In the frequency synthesizer in a wireless communication system, a signal is transmitted at a specific frequency, and the PLL system may be used to generate a precise clock signal.

The PLL system is widely used in various chips of a base station device or a terminal device, for example, a processor chip and a radio frequency chip.

In the foregoing PLL system, a spur mainly comes from a non-ideal feature of the charge pump. This application is used to improve a structure of the charge pump, to suppress the non-ideal feature of the charge pump.

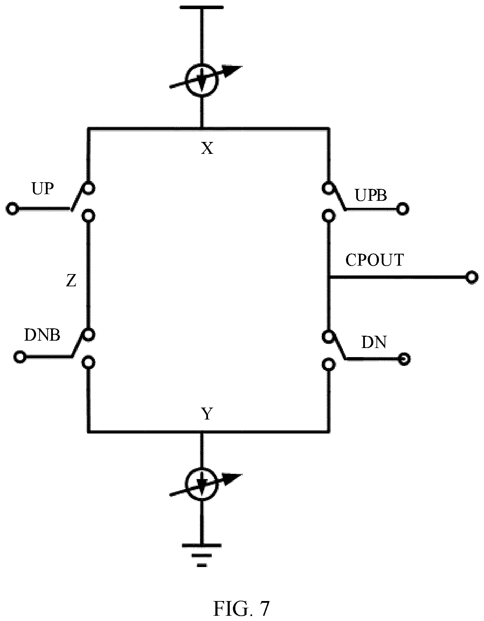

The following first describes the structure of the charge pump. A structure of a typical charge pump is shown in FIG. 7, and is a differential structure. To be specific, the charge pump includes two differential paths, one differential path is a path on which a switch UP and a switch DNB are located, and the other differential path is a path on which a switch UPB and a switch DN are located. The differential structure includes two current sources and two pairs of switches. The two pairs of switches are a switch pair including the switch UP and the switch UPB, and a switch pair including the switch DN and the switch DNB. In this way, four nodes are formed in a circuit of the charge pump: an X node, a Y node, a Z node, and a CPOUT node. The CPOUT node is an output terminal of the charge pump. To minimize DC current mismatch of the charge pump circuit and reduce a charge sharing effect, voltages of the four nodes need to be as close as possible due to a requirement of the PLL system on noise and a spur. An upper current source and a lower current source respectively correspond to different output voltage points. That the two current sources are more ideal indicates smaller current mismatch and a smaller spur. Ideally, the upper current source and the lower current source generate same currents, and the upper switches and the lower switches on each path should have a same overcurrent capability when the switches are on. An actual circuit design needs to minimize current mismatch.

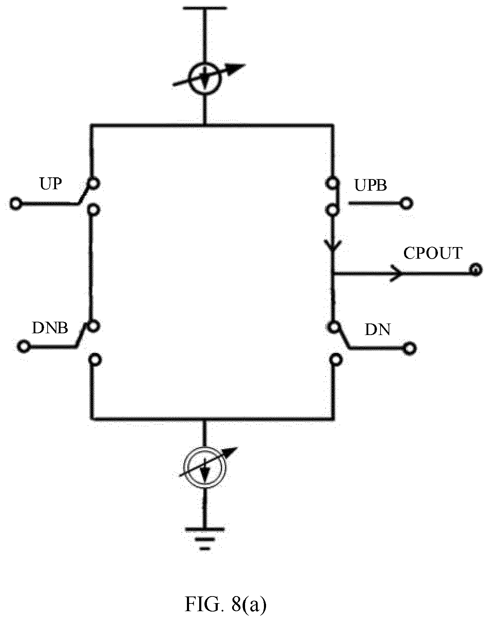

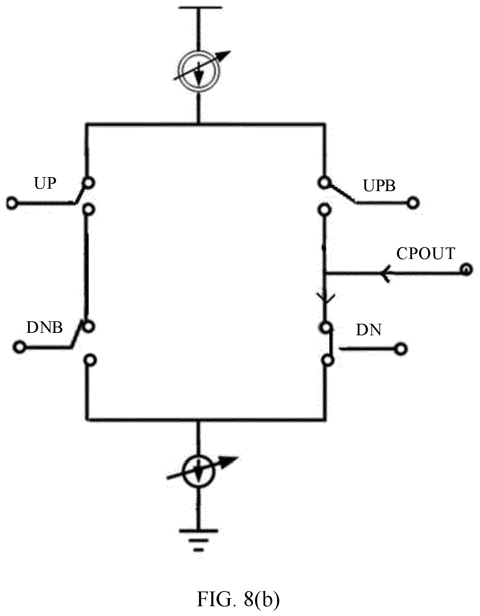

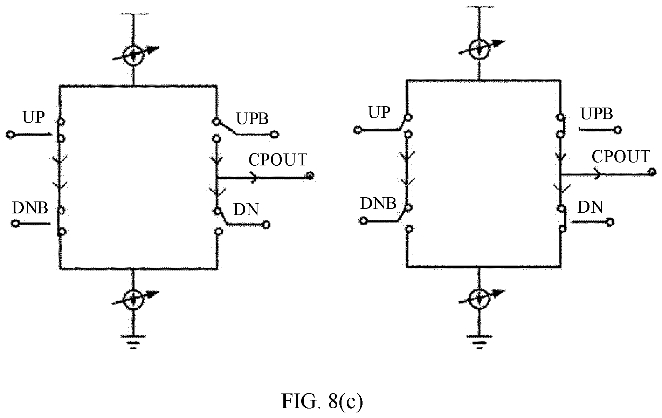

The charge pump has three working states, namely, a charging state (charging is to charge/discharge the CPOUT node in the charge pump) shown in FIG. 8(a), a discharging state shown in FIG. 8(b), and a lock state shown in FIG. 8(c). It is assumed that a control voltage $V_{ctrl}$ of the VCO is directly proportional to an output frequency, that is, the output frequency of the VCO increases as an input voltage increases. In this case, when a phase of an input reference clock leads a phase of a feedback clock in the PLL system, the charge pump is in the charging state, the switch UPB is off, the switch DN is off, and an output current of the charge pump charges a current injected by a capacitor in the LPF in the system through a UPB branch. Consequently, the control voltage $V_{ctrl}$ of the VCO increases, and the frequency of the VCO increases. When the phase of the input reference clock in the PLL system lags behind the phase of the feedback clock, the charge pump is in the discharging state. In this case, the switch UPB is off, the switch DN is off, and a charge that is stored in the capacitance is discharged to the ground by the capacitor in the LPF through a DN branch.

Consequently, the control voltage $V_{ctrl}$ of the VCO decreases, and the frequency of the VCO decreases.

When the control voltage $V_{ctrl}$ of the VCO is proportional to the output frequency, it is assumed that the phase of the reference clock is stable, the PFD and the charge pump can accurately identify a phase difference between the phase of the feedback clock and the phase of the reference clock, and the PLL system gradually decreases the phase difference by using a negative feedback function of the PLL system. When the PLL system is finally locked, the phase difference is zero. When the PLL system is locked, on the two branches on which the switch UP and the switch DN in the charge pump are located, the switches on the branch on which the switch UP is located are off at the same time, and the switches on the branch on which the switch DN is located are on at the same time. Ideally, no net charge flows into or out of the capacitor of the LPF through the CPOUT node, that is, $I_{out} = 0$. When the PLL system is locked, because the PFD generates a narrow pulse, the charge pump is in the state shown in the left figure in FIG. 8(c) for most of the time, that is, the switches above and below the CPOUT node are on. Only when the narrow pulse is input to the charge pump is the charge pump in the state shown in the right figure in FIG. 8(c), and the switches above and below the CPOUT node are off.

Ideally, when the PLL system is locked, no net charge is output through the CPOUT node, and the three working states do not seriously affect the CPOUT node. However, a plurality of non-ideal factors exist in the circuit, such as clock feedthrough, charge injection, DC current mismatch, and charge sharing. Consequently, a net charge flows into the loop filter, the voltage ripple is input to the VCO, the VCO is modulated, and a spur is introduced to the PLL system. Therefore, impact of the non-ideal factors on an output of the CPOUT node needs to be reduced.

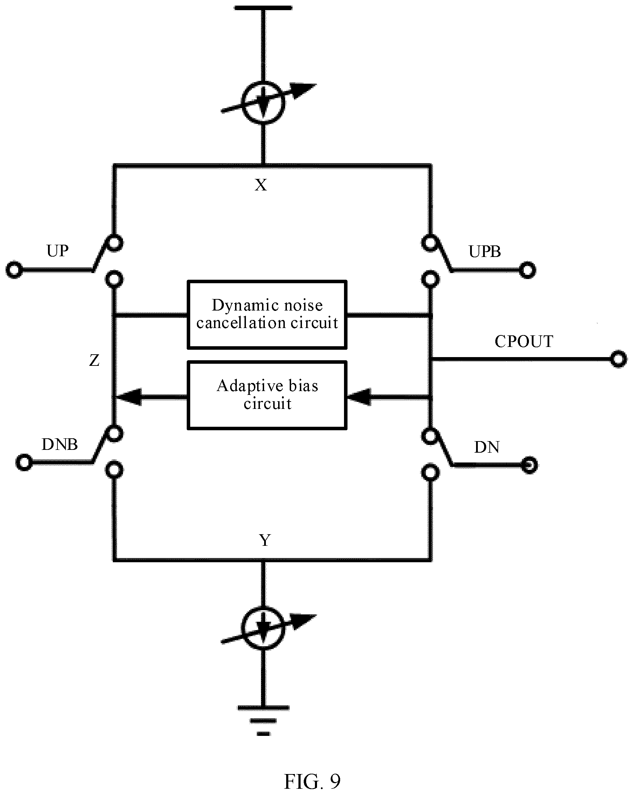

For the non-ideal factors in the charge pump, FIG. 9 is a schematic diagram of an improved charge pump according to this application. An objective of this application is to use a dynamic noise cancellation circuit and an adaptive bias circuit (adaptive bias circuit) that are shown in FIG. 9, to cancel a glitch generated when the switch in the circuit performs voltage level shifting, reduce DC current mismatch, and enable the CPOUT node to operate within a wide voltage range. The dynamic noise cancellation circuit may also be referred to as a glitch cancellation (glitch cancellation) circuit.

The glitch cancellation circuit in this application is configured to reduce a glitch or a narrow pulse generated at a switching moment of the switch in the charge pump. This reduces impact of clock feedthrough and charge injection on the circuit. The adaptive bias circuit in this application may provide a bias point for the charge pump circuit, so that voltages of nodes connected to switch transistors in the charge pump circuit are consistent. This reduces the charge sharing effect, and reduces DC current mismatch between the upper current source and the lower current source.

For two non-ideal factors, clock feedthrough and charge injection, in the charge pump, the glitch cancellation circuit in this application is implemented by adding an auxiliary transistor to a basic structure of the charge pump. Therefore, the charge pump provided in this application includes a pair of current sources, and two differential paths that are connected in parallel and that are between the pair of current sources. The charge pump further includes a plurality of pairs of switch transistors, and each pair of switch transistors are respectively disposed on the two differential paths.

The charge pump further includes an auxiliary transistor in a one-to-one correspondence with the switch transistor, and sources of two auxiliary transistors corresponding to each pair of switch transistors are connected to each other.

A gate of each auxiliary transistor is connected to a gate of a corresponding switch transistor.

A drain of each auxiliary transistor is connected to a drain of a peer switch transistor of a corresponding switch transistor.

It can be seen that in the glitch cancellation circuit provided in this application, auxiliary transistors corresponding to the plurality of pairs of switch transistors are added to the structure of the existing charge pump.

In this embodiment of this application, in each pair of switch transistors, one switch transistor is a peer switch transistor of the other switch transistor. Each pair of switch transistors may also be referred to as a differential pair. Differential signals input from gates of the differential pair are complementary, and the differential pair is a common-source structure. That the differential signals are complementary means that when an input voltage level of one switch transistor is high, an input voltage level of the other switch transistor is low.

In this embodiment of this application, a connection between components or ports may be a direct connection, or may be an indirect connection. For example, a component such as a capacitor is connected between components.

The switch in this embodiment of this application may be a MOS transistor, for example, a PMOS transistor or an NMOS transistor.

It can be learned from the foregoing two non-ideal factors, clock feedthrough and charge injection, that at a switching moment of a switch on each differential path in the charge pump, a gate voltage of the switch causes a current glitch or a narrow pulse current generated at a drain of the switch, and input to a loop through the CPOUT node in the charge pump. Because differential signals of each pair of switch transistors are complementary, when a voltage provided to one switch transistor is switched from a turn-on level to a turn-off level, the other switch transistor switches from a turn-off level to a turn-on level. For example, when a pair of switch transistors are PMOS transistors, and one PMOS transistor being on at a low voltage level, the other PMOS transistor being off at a high voltage level. When a pair of switch transistors are NMOS transistors, and one NMOS transistor being on at a high voltage level, the other NMOS transistor being off at a low voltage level. A drain of the switch transistor that is on or off generates a current glitch. For example, a gate of an auxiliary transistor connected to a gate of a switch transistor that is off is also switched to a high voltage level, and a drain of the auxiliary transistor varies with a gate voltage of the auxiliary transistor. Consequently, the drain of the auxiliary transistor also generates a current glitch. Because the gate voltage of the auxiliary transistor and a gate voltage of a switch transistor that is on are opposite in phase, and the drain of the auxiliary transistor is connected to a drain of the switch transistor that is on, the current glitch generated by the drain of the auxiliary transistor and a current glitch generated by the drain of the switch transistor that is on are close in size and opposite in direction. Consequently, when two current glitches are added, the current glitch originally transmitted to the CPOUT node can be canceled.

An advantage of a structure of the glitch cancellation circuit using an auxiliary transistor in this application is that a relatively compact layout can be designed. The glitch cancellation circuit in this application has a simple structure and a small layout area without an extra circuit module. In addition, because the auxiliary transistor is not connected to a DC path, no DC current passes through. Therefore, no extra DC power consumption is generated in the structure of the glitch cancellation circuit in this application. In addition, the structure may be used to suppress a spur in the non-ideal factors of the charge pump due to switch switching. The glitch cancellation circuit in this application is applicable to any scenario, for example, a charge pump scenario at a relatively high frequency.

The following further describes the glitch cancellation circuit by using the typical charge pump shown in FIG. 9 as a basic structure of the charge pump.

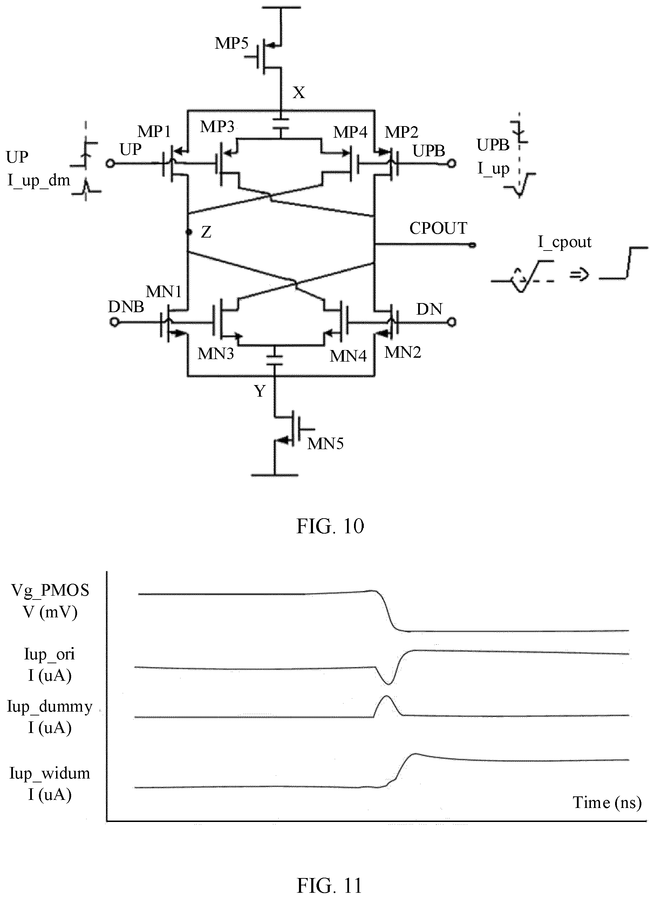

When the plurality of pairs of switch transistors are two pairs of switch transistors, and an auxiliary transistor is added to the typical charge pump shown in FIG. 9, a structure of a charge pump in this application may be shown in FIG. 10.

Refer to FIG. 10. The two pairs of switch transistors include a switch pair including a first switch transistor MP1 and a second switch transistor MP2, and a switch pair including a third switch transistor MN1 and a fourth switch transistor MN2.

The two differential paths include a first differential path and a second differential path, the first differential path includes the first switch transistor MP1 and the third switch transistor MN1, and the second differential path includes the second switch transistor MP2 and the fourth switch transistor MN2.

The auxiliary transistors that are in a one-to-one correspondence with the two pairs of switch transistors include a first auxiliary transistor MP3, a second auxiliary transistor MP4, a third auxiliary transistor MN3, and a fourth auxiliary transistor MN4. The first switch transistor MP1 corresponds to the first auxiliary transistor MP3, the second switch transistor MP2 corresponds to the second auxiliary transistor MP4, the third switch transistor MN1 corresponds to the third auxiliary transistor MN3, and the fourth switch transistor MN2 corresponds to the fourth auxiliary transistor MN4.

The pair of current sources includes a first current source and a second current source, the first current source includes a first transistor MP5, and the second current source includes a second transistor MN5.

MP1, MP2, MP3, MP4, and MP5 are PMOS transistors, and MN1, MN2, MN3, MN4, and MN5 are NMOS transistors.

It can be seen that the glitch cancellation circuit provided in this application is obtained by adding auxiliary transistors MP3, MP4, MN3, and MN4 to the charge pump in FIG. 7.

Refer to FIG. 10. In terms of connection relationships between switches, a connection relationship may be as follows: a source of the first switch transistor MP1 is connected to a source (S electrode) of the second switch transistor MP2, and both the source of the first switch transistor MP1 and the source of the second switch transistor MP2 are connected to a drain (D electrode) of the first transistor MP5, where a connection point is denoted as an X node. A source of the third switch transistor MN1 is connected to a source of the fourth switch transistor MN2, and the source of the third switch transistor MN1 and the source of the fourth switch transistor MN2 are connected to a drain of the second transistor MN5, where a connection point is denoted as a Y node. A drain of the first switch transistor MP1 is connected to a drain of the third switch transistor MN1, and a drain of the second switch transistor MP2 is connected to a drain of the fourth switch transistor MN2.

A gate of the first switch transistor MP1 is connected to a gate of the first auxiliary transistor MP3, a gate of the second auxiliary transistor MP4 is connected to a gate of the second switch transistor MP2, and a gate of the third switch transistor MN1 is connected to a gate of the third auxiliary transistor MN3. A gate of the fourth switch transistor MN2 is connected to a gate of the fourth auxiliary transistor MN4.

A source of the first auxiliary transistor MP3 is connected to a source of the second auxiliary transistor MP4, and a source of the third auxiliary transistor MN3 is connected to a source of the fourth auxiliary transistor MN4. A drain of the first auxiliary transistor MP3 is connected to the drain of the second switch transistor MP2, a drain of the second auxiliary transistor MP4 is connected to the drain of the first switch transistor MP1, a drain of the third auxiliary transistor MN3 is connected to the drain of the fourth switch transistor MN2, and a drain of the fourth auxiliary transistor MN4 is connected to the drain of the second auxiliary transistor MN1.

Based on the glitch cancellation circuit in FIG. 10, the gate of the auxiliary transistor is connected to the gate of the corresponding switch transistor, and the drain of the auxiliary transistor is connected to the drain of the peer switch transistor of the corresponding switch transistor. When the switch transistor is on or off, it can be learned from two effects of clock feedthrough and charge injection that a gate voltage causes a current glitch generated at the drain. As shown in FIG. 10, a current glitch in a down direction is generated when the switch UPB is on, and is denoted as I_up in FIG. 10. The switch UP and the switch UPB are opposite in phase. When the switch UPB and the switch DN are on, the switch UP and the switch DNB are off. When the switch UP and the switch DNB are on, the switch UPB and the switch DN are off.

In this embodiment of this application, each pair of switch transistors are respectively disposed on the two differential paths, and one switch transistor in each pair of switch transistors is a peer switch transistor of the other switch transistor.

Refer to FIG. 10. Specifically, when the first switch transistor MP1 is off, and the second switch transistor MP2 is on, or when the first switch transistor MP1 is on, and the second switch transistor MP2 is off, a gate voltage of the first auxiliary transistor MP3 varies with a gate voltage of the first switch transistor MP1, and a gate voltage of the second auxiliary transistor MP4 varies with a gate voltage of the second switch transistor MP2; a first pulse current is generated at the drain of the first switch transistor MP1, and a second pulse current is generated at the drain of the second auxiliary transistor MP4, where the first pulse current and the second pulse current are equal in size and opposite in direction; and a third pulse current is generated at the drain of the second switch transistor MP2, a fourth pulse current is generated at the drain of the first auxiliary transistor MP3, where the third pulse current and the fourth pulse current are equal in size and opposite in direction.

For example, when the second switch transistor MP2 and the fourth switch transistor MN2 on the second differential path are on, the first switch transistor MP1 and the third switch transistor MN1 on the first differential path are off. Therefore, when the reverse current glitch I_up is generated at the drain of the second switch transistor MP2, the gate voltage of the first auxiliary transistor MP3 varies with the gate voltage of the first switch transistor MP1, which causes a reverse current glitch I_up_dm, namely, a current glitch in an up direction, generated at the drain of the first auxiliary transistor MP3. When the current glitch generated by the first auxiliary transistor MP3 and the current glitch generated by the second switch transistor MP2 are added, because two current glitches are close in size and opposite in direction and are generated at the same time, the current glitch originally transmitted to the output terminal CPOUT may be canceled, for example, an I cpout in FIG. 10. Similarly, current glitches generated by the first switch transistor MP1, the third switch transistor MN1, and the fourth switch transistor MN2 are also canceled by current glitches generated by the corresponding auxiliary transistors.

The glitch cancellation circuit provided in this application is used to establish a simulation test circuit for verification. FIG. 11 shows a simulation result obtained by the glitch cancellation circuit in this application based on the foregoing example.

The PMOS transistor is used as an example. In FIG. 10, when the second switch transistor MP2 is off at a high voltage level, if a voltage of the second switch transistor MP2 is converted from being off at a high voltage level to being on at a low voltage level, voltage conversion of the second switch transistor MP2 may be shown as a curve Vg_PMOS in FIG. 11, and a current change of the drain of the second switch transistor MP2 may be shown as a curve Iup_ori in FIG. 11. It can be seen that at a moment when the second switch transistor MP2 is on, a reverse-phase current glitch is generated at the drain, and is generated by the non-ideal feature of the switch transistor. However, in this case, the first auxiliary transistor MP3 varies with the first switch transistor MP1, the first switch transistor MP1 and the second switch transistor MP2 are opposite in phase, and the first auxiliary transistor MP3 and the second switch transistor MP2 are opposite in phase, that is, the first auxiliary transistor MP3 is off. In addition, because no power supply provides a current for the first auxiliary transistor MP3, a current glitch, shown as a curve Iup_dummy in FIG. 11, is generated at the drain of the first auxiliary transistor MP3, where the current glitch and the current glitch generated at the drain of the second switch transistor MP2 are opposite in direction. When a size of the first auxiliary transistor MP3 is the same as a size of the second switch transistor MP2, and mismatch is very small, the current glitch generated by the first auxiliary transistor MP3 and the current glitch generated by the second switch transistor MP2 are same in size and are generated at the same time. Therefore, at the output terminal CPOUT of the charge pump, the current glitch may be canceled at a moment when the switch is on or off. A current curve after the glitch is canceled may be shown as a curve Iup widum in FIG. 11.

The self-biased circuit provided in this application is configured to adjust a voltage of the node between the drains of the two switch transistors on one differential path to be equal to a voltage of the output node, namely, the CPOUT node, between the two switch transistors on the other differential path. The principle of the charge pump shown in FIG. 7 is used as an example. This application is used to adjust a voltage of the Z node to be equal to a voltage of the CPOUT node.

Specifically, the self-biased circuit in this application is configured to adjust, based on the voltage of the output node, a current of the self-biased circuit, so that the voltage of the node between the two switch transistors on the other differential path is equal to the voltage of the output node.

A principle of the self-biased circuit provided in this application may be: the self-biased circuit includes a series of bias transistors and current mirrors, and when a size of a transistor in the current mirror is well-adjusted, a current of the transistor in the current mirror structure can well vary with a voltage. In this way, when the voltage of the output node on the first differential path changes, a current of the bias transistor and a current of the current mirror reflect a change of the voltage. In other words, the current of the self-biased circuit may vary with the voltage of the output node, and the voltage of the node between the drains of the two switch transistors on the second differential path varies with the current of the self-biased circuit. Therefore, the voltage of the node between the drains of the two switch transistors on the other differential path varies with the voltage of the output node on the first differential path.

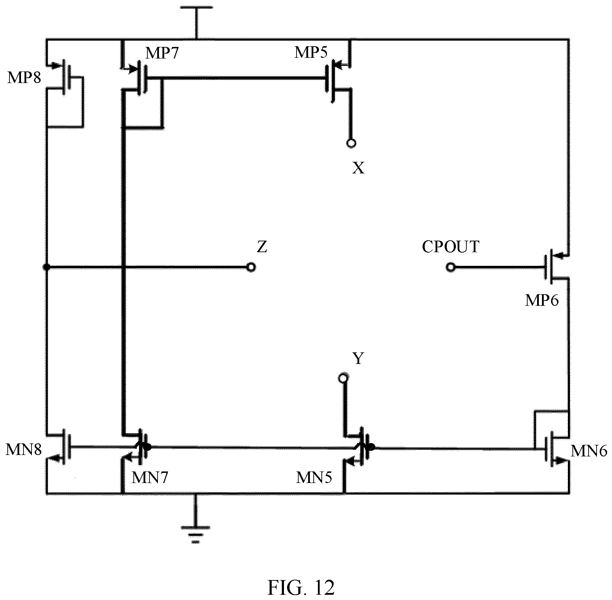

Based on the principle of the self-biased circuit provided in this application, the principle of the charge pump shown in FIG. 7 is used as an example. FIG. 12 is a schematic diagram of a structure of the self-bias circuit provided in this application. Refer to FIG. 12. The self-biased circuit in this application may include a first bias transistor MP6 connected to the CPOUT node, a plurality of bias transistors (MN6, MN7, MN8, and MP7) that form current mirror structures with the pair of current sources (the switch transistor MP5 and the switch transistor MN5), and a second bias transistor MP8 connected to the current mirror structure.

The bias transistor in this application may be a MOS transistor.

Specifically, the pair of current sources includes a first transistor MP5 and a second transistor MN5; the bias transistor that forms a current mirror structure with the second transistor MN5 includes the third bias transistor MN6, the fourth bias transistor MN7, and the fifth bias transistor MN8; and the bias transistor that forms a current mirror structure with the first transistor MP5 includes the sixth bias transistor MP7.

Refer to FIG. 12. For a connection structure of the self-biased circuit, a gate of the first bias transistor MP6 is coupled to the output node CPOUT, a first terminal of the first bias transistor MP6 is coupled to the first transistor MP5, and a second terminal of the first bias transistor MP6 is coupled to a first terminal of the third bias transistor MN6;

a gate of the third bias transistor MN6 is coupled to a gate of the second transistor MN5, a second terminal of the third bias transistor MN6 is coupled to a first terminal of the second transistor MN5, and the gate of the third bias transistor MN6 is coupled to the second terminal of the third bias transistor MN6;

a gate of the fourth bias transistor MN7 is coupled to a gate of the second current source MN5, a first terminal of the fourth bias transistor MN7 is coupled to the first terminal of the second transistor MN5, and a second terminal of the fourth bias transistor MN7 is coupled to a second terminal of the sixth bias transistor MP7;

a gate of the fifth bias transistor MN8 is coupled to the gate of the fourth bias transistor MN7, a first terminal of the fifth bias transistor MN8 is coupled to the first terminal of the second transistor MN5, and a second terminal of the fifth bias transistor MN8 is coupled to a second terminal of the second transistor MN5;

a gate of the sixth bias transistor MP7 is coupled to a gate of the first transistor MP5, a first terminal of the sixth bias transistor MP7 is coupled to a first terminal of the first transistor MP5, and the gate of the sixth bias transistor MP7 is coupled to a second terminal of the sixth bias transistor MP7;

a first terminal of the second bias transistor MP8 is coupled to the first terminal of the first transistor MP5, and a gate of the second bias transistor MP8 is coupled to a second terminal of the second bias transistor MP8; and

a node between the second terminal of the second bias transistor MP8 and the second terminal of the fifth bias transistor MN8 is coupled to a Z node between the switch transistors on the other differential path.

It can be learned from the foregoing charge sharing effect and DC current mismatch, to minimize the current mismatch of the charge pump circuit and reduce the charge sharing effect, voltages of the X node, the Y node, the Z node, and the CPOUT node need to be as close as possible due to a requirement of the system on noise and a spur. That currents of an upper current source and a lower current source in the circuit are closer indicates smaller current mismatch.

Based on the self-biased circuit provided in FIG. 12, for example, when the voltage of the CPOUT node increases, it is assumed that a supply voltage of the charge pump remains unchanged (the supply voltage - the voltage of the CPOUT node = a gate voltage of MP6), a gate voltage of the first bias transistor MP6 decreases, a current of the first bias transistor MP6 decreases, a current of the second transistor MN5 and currents of the bias transistor MN6, the bias transistor MN7, and the bias transistor MN8 that form a current mirror structure with the second transistor MN5 decrease, a current of the first transistor MP5 and a current of the sixth bias transistor MP7 that form a current mirror structure with the first transistor MP5 decrease, a voltage of a node between a drain of the second bias transistor MP8 and a drain of the fifth bias transistor MN8 increases, and the voltage of the Z node between the switch transistor MP1 and the switch transistor MN1 on the other differential path increases. In this case, because differential switch signals are complementary, when one differential path is on, and the other differential path is off, the voltage of the X node and the voltage of the Y node are equal to the voltage of the Z node. When the voltage of the Z node increases, the voltage of the X node and the voltage of the Y node increase.

When the voltage of the CPOUT node decreases, because a supply voltage of the charge pump remains unchanged, a gate voltage of the first bias transistor MP6 increases, a current of the first bias transistor MP6 increases, a current of the second transistor MN5 and currents of the bias transistor MN6, the bias transistor MN7, and the bias transistor MN8 that form a current mirror structure with the second transistor MN5 increase, a current of the first transistor MP5 and a current of the sixth bias transistor MP7 that form a current mirror structure with the first transistor MP5 increase, a voltage of a node between a drain of the second bias transistor MP8 and a drain of the fifth bias transistor MN8 decreases, the voltage of the Z node between the switch transistor MP1 and the switch transistor MN1 on the other differential path decreases, and the voltage of the X node and the voltage of the Y node decrease.

In other words, in the self-biased circuit provided in this application, the current of the first bias transistor MP6 varies with the voltage of the CPOUT node. Then, a change of the current of the first bias transistor MP6 is mirrored in the second transistor MN5, the fourth bias transistor MN7, and the fifth bias transistor MN8 by using the third bias transistor MN6. Similarly, a change of the current of the fourth bias transistor MN7 is also reflected in the sixth bias transistor MP7, and is mirrored in the first transistor MP5. A change of the current of the fifth bias transistor MN8 is also reflected in the second bias transistor MP8. The current of the second transistor MN5 is a current of the switch DN, and the current of the first transistor MP5 is a current of the switch UP. Therefore, currents of the switch UP and the switch DN change synchronously. A change of a current is eventually reflected in a voltage. Therefore, the voltage of the node between the drain of the second bias transistor MP8 and the drain of the fifth bias transistor MN8 or the voltage of the Z node between the drain of the first switch transistor MP1 and the drain of the third switch transistor MN1, the voltage of the X node, and the voltage of the Y node varies/vary with the current. In other words, the voltages of the three nodes vary with the voltage of the CPOUT node. This cancels the charge sharing effect caused by different voltages of nodes. In addition, because currents of the second transistor MN5 and the first transistor MP5 synchronously vary with the voltage of the CPOUT node, the DC current mismatch effect caused by mismatch between the currents of the switch UP and the switch DN can be suppressed.

Therefore, the self-biased circuit provided in this application may be used to achieve an adaptive bias effect, and reduce a requirement for an extra bias circuit. In addition, relatively small power consumption is required, and a layout area is compact. Because there is no extra complex system such as an operational amplifier and a glitch detection circuit, a response speed is fast, and the charge pump may be used in a high-speed system. In addition, the charge pump in this application may be widely adaptable, and may be placed in a plurality of different PLL systems. Because a structure of the charge pump is simple, the charge pump in this application is very reliable in different CMOS processes. The charge pump provided in this application has especially good performance in a relatively wide output voltage range.

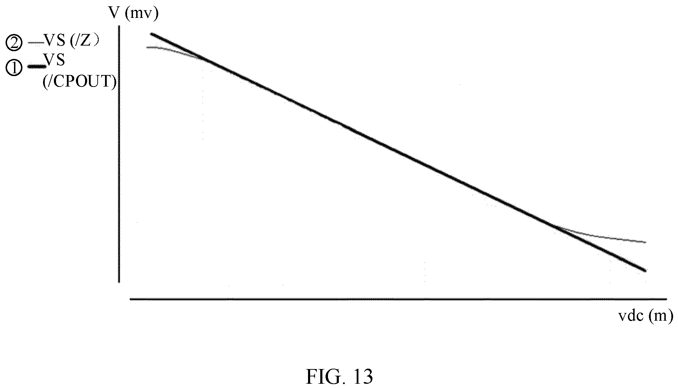

The self-biased circuit provided in this application is used to establish a simulation test circuit for verification. FIG. 13 shows a simulation result obtained by the self-biased circuit in this application based on the foregoing example in FIG. 12.

Refer to FIG. 13. The voltage of the Z node can well vary with the voltage of the CPOUT node in a specific range. In FIG. 13, a curve (1) reflects a change of the voltage of the CPOUT node, and a curve (2) reflects a change of the voltage of the Z node. When the voltage of the CPOUT node is small or large, because the MOS transistor in the bias circuit enters a linear region, the voltage of the Z node does not vary with the voltage of the CPOUT node. However, the voltage of the Z node can vary with the voltage of the CPOUT node for most of the time. This can effectively reduce impact brought by the charge sharing and the DC current mismatch.

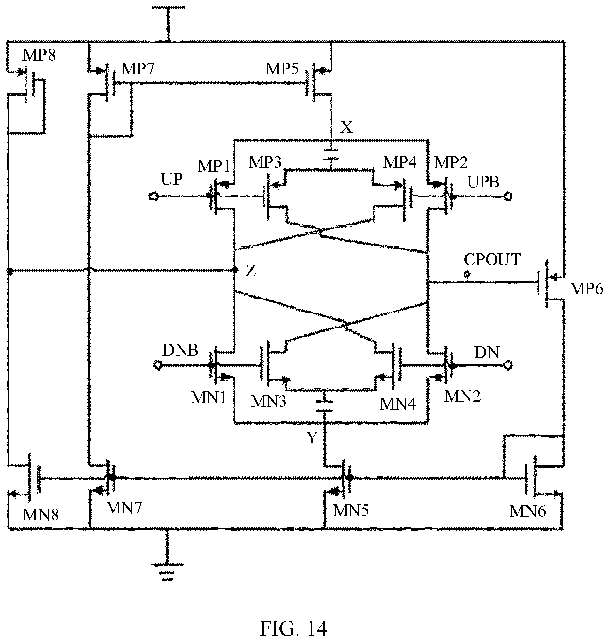

If the glitch cancellation circuit and the self-biased circuit provided in this application are combined with the structure of the typical charge pump shown in FIG. 7, a diagram of a structure of a charge pump provided in this application may be shown in FIG. 14. In this way, when the charge pump provided in this application works, the glitch cancellation circuit may be used to reduce a current glitch generated at a switching moment of a switch transistor, to reduce impact of a clock feedthrough effect and a charge injection effect on the circuit. In addition, the self-biased circuit may be used to make voltages of all nodes in the charge pump tends to be consistent, to reduce a charge sharing effect, and adjust voltages of the UP current source and the DN current source, to reduce mismatch between an upper DC current and the lower DC current.

A channel length modulation effect of a transistor such as a MOS transistor is considered. A simple mirror relationship of a current mirror including two bias transistors may be described as the following formula:

$$I_{D2}/I_{D1} = [(W/L)_2/(W/L)_1] \times [(1 + \lambda V_{DS2})/(1 + \lambda V_{DS1})]$$

$I_{D2}$ and $I_{D1}$ indicate currents of drains of two MOS transistors, W/L indicates a width-to-length ratio of a MOS transistor, $\lambda$ is a coefficient, and $V_{DS2}$ and $V_{DS1}$ indicate source-drain voltages of the two MOS transistors.

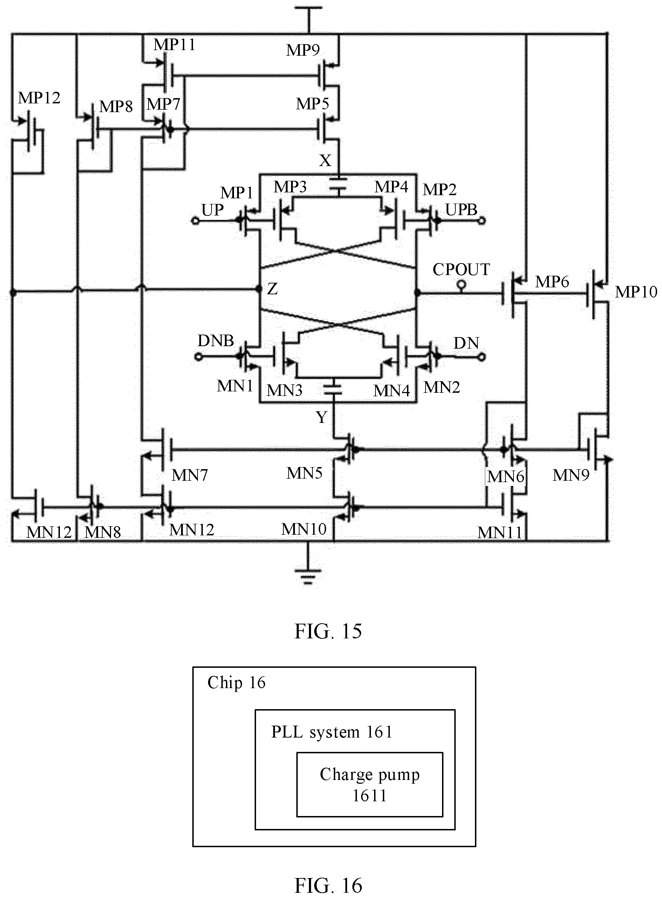

According to the foregoing formula, the current of the switch UP needs to be equal to the current of the switch DN in the charge pump. Ideally, a drain voltage of the first transistor MP5 needs to be equal to a drain voltage of the sixth bias transistor MP7. However, in a circuit structure shown in FIG. 14, when the drain voltage of the first transistor MP5 is not equal to the drain voltage of the sixth bias transistor MP7, specific mismatch still exists between the upper current source and the lower current source. Therefore, to further reduce the mismatch between the upper current source and the lower current source, the current source in the self-biased circuit in this application may use a cascode structure, and a corresponding self-biased circuit varies with a structure of the current source. FIG. 15 is a schematic diagram of a structure of the charge pump with the cascode structure. The first transistor MN5 and a transistor MN10 form a current source with a cascode structure, and the first transistor MP5 and a transistor MP9 form a current source with a cascode structure. In the structure, the self-biased circuit in this application includes bias transistors MP6, MP10, MN6, MN9, MN11, MN7, MN12, MN8, MN12, MP12, MP8, MP7, and MP11.

Based on a definition of the current source, when the current source has infinite internal resistance, a current output by the current source remains unchanged and does not vary with an external circuit of the current source. In this case, when the current source in this application uses a cascode structure, output impedance of the current source may be multiplied, so that the current source tends to be an ideal current source, and outputs a constant current. This further reduces mismatch between an upper current source and a lower current source in the charge pump.

Similarly, to achieve better effects, there may be three or more layers of current sources with cascode structures, to better reduce mismatch between the current sources.

As shown in FIG. 16, an embodiment of this application provides a chip 16. A PLL system 161 provided in this application is disposed on the chip. The PLL system 161 includes a structure of any charge pump described in FIG. 9, FIG. 10, FIG. 12, FIG. 14, and FIG. 15.

The chip 16 may be any chip used in the communication field. For example, the chip 16 may be a CPU, a clock tree, a frequency synthesizer, or the like.

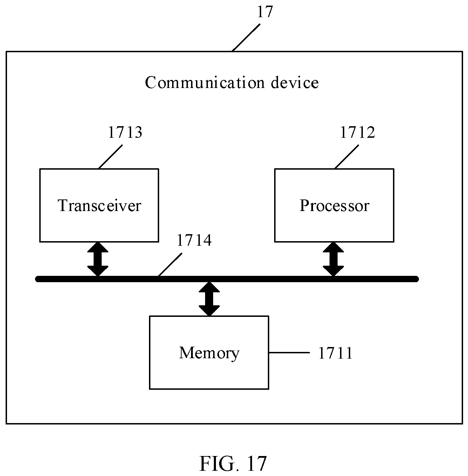

As shown in FIG. 17, an embodiment of this application further provides a communication device 17. The communication device 17 may be a mobile terminal, a base station, or the like. The communication device 17 includes a processor 1712, a transceiver 1713, a memory 1711, and a bus 1714. The chip 16 may be applied to the transceiver 1713, and may suppress a spur of the transceiver 1713 in the PLL system when the transceiver 1713 receives and sends a signal.

The transceiver 1713, the processor 1712, and the memory 1711 are connected to each other through the bus 1714. The bus 1714 may be a peripheral component interconnect (Peripheral Component Interconnect, PCI) bus, an extended industry standard architecture (Extended Industry Standard Architecture, EISA) bus, or the like. The bus may be classified into an address bus, a data bus, a control bus, or the like. For ease of representation, only one thick line is used to indicate the bus in FIG. 17, but this does not mean that there is only one bus or only one type of bus.

The foregoing description is merely a specific implementation of this application, but is not intended to limit the protection scope of this application. Any variation or replacement within the technical scope disclosed in this application shall fall within the protection scope of this application. Therefore, the protection scope of this application shall be subject to the protection scope of the claims.

**Claims**

1. A phase-locked loop, PLL, comprising a charge pump, wherein the charge pump comprises a pair of current sources and two differential paths, the charge pump further comprises a first switch transistor and a second switch transistor, and the first switch transistor and the second switch transistor are respectively disposed on the two differential paths;

   the charge pump further comprises a first auxiliary transistor and a second auxiliary transistor;
   a gate of the first auxiliary transistor is coupled to a gate of the first switch transistor, and a gate of the second auxiliary transistor is coupled to a gate of the second switch transistor;
   a first terminal of the first switch transistor is coupled to a first current source, and a second terminal of the first switch transistor is coupled to a second current source;
   a first terminal of the second switch transistor is coupled to the first current source, and a second terminal of the second switch transistor is coupled to the second current source;
   a first terminal of the first auxiliary transistor is coupled to the first current source, and a second terminal of the first auxiliary transistor is coupled to the second terminal of the second switch transistor; and
   a first terminal of the second auxiliary transistor is coupled to the first current source, and a second terminal of the second auxiliary transistor is coupled to the second terminal of the first switch transistor.

2. The PLL according to claim 1, wherein differential voltages are separately input to the gate of the first switch transistor and the gate of the second switch transistor.

3. The PLL according to claim 1 or 2, wherein

when the first switch transistor is off, and the second switch transistor is on, or when the first switch transistor is on, and the second switch transistor is off,

a gate voltage of the first auxiliary transistor varies with a gate voltage of the first switch transistor, and a gate voltage of the second auxiliary transistor varies with a gate voltage of the second switch transistor;

a first pulse current is generated at the second terminal of the first switch transistor, and a second pulse current is generated at the second terminal of the second auxiliary transistor, wherein the first pulse current and the second pulse current are equal in size and opposite in direction; and

a third pulse current is generated at the second terminal of the second switch transistor, a fourth pulse current is generated at the second terminal of the first auxiliary transistor, wherein the third pulse current and the fourth pulse current are equal in size and opposite in direction.

4. The PLL according to any one of claims 1 to 3, wherein the charge pump comprises an output node disposed between two switch transistors on one of the two differential paths, the charge pump further comprises a self-biased circuit, and the self-biased circuit is configured to adjust a voltage of a node between two switch transistors on the other differential path of the two differential paths based on a voltage of the output node.

5. The PLL according to claim 4, wherein the self-biased circuit enables the voltage of the node between the two switch transistors on the other differential path to vary with a voltage of the output node.

6. The PLL according to claim 4 or 5, wherein the self-biased circuit comprises a first bias transistor connected to the output node, a plurality of bias transistors that form current mirror structures with the pair of current sources, and a second bias transistor connected to the current mirror structure.

7. The PLL according to claim 6, wherein the first current source comprises a first transistor, and the second current source comprises a second transistor; the bias transistor that forms a current mirror structure with the second transistor comprises a third bias transistor, a fourth bias transistor, and a fifth bias transistor; and the bias transistor that forms a current mirror structure with the first transistor comprises a sixth bias transistor.

8. The PLL according to claim 7, wherein

a gate of the first bias transistor is coupled to the output node, a first terminal of the first bias transistor is coupled to the first current source, and a second terminal of the first bias transistor is coupled to a first terminal of the third bias transistor;

a gate of the third bias transistor is coupled to a gate of the second transistor, a second terminal of the third bias transistor is coupled to a first terminal of the second transistor, and the gate of the third bias transistor is coupled to the second terminal of the third bias transistor;

a gate of the fourth bias transistor is coupled to a gate of the second current source, a first terminal of the fourth bias transistor is coupled to the first terminal of the second transistor, and a second terminal of the fourth bias transistor is coupled to a second terminal of the sixth bias transistor;

a gate of the fifth bias transistor is coupled to the gate of the fourth bias transistor, a first terminal of the fifth bias transistor is coupled to the first terminal of the second transistor, and a second terminal of the fifth bias transistor is coupled to a second terminal of the second transistor;

a gate of the sixth bias transistor is coupled to a gate of the first transistor, a first terminal of the sixth bias transistor is coupled to a first terminal of the first transistor, and the gate of the sixth bias transistor is coupled to a second terminal of the sixth bias transistor;

a first terminal of the second bias transistor is coupled to the first terminal of the first transistor, and a gate of the second bias transistor is coupled to a second terminal of the second bias transistor; and

a node between the second terminal of the second bias transistor and the second terminal of the fifth bias transistor is coupled to a node between the switch transistors on the other differential path.

9. The PLL according to claim 8, wherein

when the voltage of the output node increases, a gate voltage of the first bias transistor decreases, a current of the first bias transistor decreases, a current of the second transistor and a current of the bias transistor that forms a current mirror structure with the second transistor decrease, a current of the first transistor and a current of the bias transistor that forms a current mirror structure with the first transistor decrease, a voltage of the node between the second terminal of the second bias transistor and the second terminal of the fifth bias transistor increases, and a voltage of the node between the two switch transistors on the other differential path increases; or

when the voltage of the output node decreases, a gate voltage of the first bias transistor increases, a current of the first bias transistor increases, a current of the second transistor and a current of the bias transistor that forms a current mirror structure with the second transistor increase, a current of the first transistor and a current of the bias transistor that forms a current mirror structure with the first transistor increase, a voltage of the node between the second terminal of the second bias transistor and the second terminal of the fifth bias transistor decreases, and a voltage of the node between the two switch transistors on the other differential path decreases.

10. The PLL according to any one of claims 1 to 9, wherein at least one of the two current sources comprises a cascode structure of at least two stages.

11. The PLL according to any one of claims 1 to 10, wherein the PLL further comprises a phase frequency detector PFD, a loop filter LPF, a voltage-controlled oscillator VCO, and a frequency divider;

a first terminal of the PFD is coupled to a first terminal of the charge pump;
a second terminal of the charge pump is coupled to a first terminal of the LPF;
a second terminal of the LPF is coupled to a first terminal of the VCO;
a second terminal of the VCO is coupled to a first terminal of the frequency divider; and
a node between the second terminal of the VCO and the frequency divider is coupled to a second terminal of the PFD.

12. The PLL according to claim 11, wherein

the PFD is configured to perform discrete-time sampling on a phase difference between an input reference frequency and a frequency fed back by the feedback frequency divider, to obtain a discrete-time phase difference signal;
the LPF is configured to integrate and hold a discrete-time charge signal output by the charge pump, to output a voltage signal;
the VCO is configured to obtain an expected signal frequency and an expected phase based on the voltage signal output by the LPF; and
the frequency divider comprises an input divider, an output divider, and a feedback frequency divider, wherein the input divider is configured to: divide the input reference frequency, and input a divided frequency to the PFD, the output divider is configured to divide and output the frequency of the VCO, and the feedback frequency divider is configured to: divide the feedback frequency, and input a divided frequency to the PFD.

13. A phase-locked loop PLL, comprising a phase frequency detector PFD, a charge pump, a loop filter LPF, a voltage-controlled oscillator VCO, and a frequency divider, wherein the charge pump comprises two differential paths and a self-biased circuit, the self-biased circuit is configured to adjust, based on a voltage of an output node between two switch transistors on one differential path, a voltage of node between two switch transistors on the other differential path.

14. The PLL according to claim 13, wherein the self-biased circuit enables the voltage of the node between the two switch transistors on the other differential path to vary with the voltage of the output node.

FIG. 1

FIG. 2

$V_g$

$I_g$

PMOS

$C_{gd}$

FIG. 3

PMOS

Electron hole

$V_{out}$

Electron

Cap

NMOS

FIG. 4

FIG. 5

FIG. 6

FIG. 7

FIG. 8(a)

UP

UPB

CPOUT

DNB

DN

FIG. 8(b)

FIG. 8(c)

FIG. 9

FIG. 10

FIG. 11

FIG. 12

V (mv)

② —VS (/Z)
① —VS (/CPOUT)

vdc (m)

FIG. 13

FIG. 14

FIG. 15

FIG. 16

17

Communication device

1713

Transceiver

1712

Processor

1714

Memory

1711

FIG. 17

## INTERNATIONAL SEARCH REPORT

| International application No. |
| --- |
| **PCT/CN2019/088214** |

| A. | CLASSIFICATION OF SUBJECT MATTER |
| --- | --- |

H03L 7/08(2006.01)i; H03L 7/089(2006.01)n; H03L 7/18(2006.01)n

According to International Patent Classification (IPC) or to both national classification and IPC

| B. | FIELDS SEARCHED |
| --- | --- |

Minimum documentation searched (classification system followed by classification symbols)

H03L

Documentation searched other than minimum documentation to the extent that such documents are included in the fields searched

Electronic data base consulted during the international search (name of data base and, where practicable, search terms used)

CNKI; CNPAT; WPI; EPODOC: 减小, 差分对, MOS管, PMOS管, 辅助管, 窄脉冲, 路径, 电荷泵, 差分, 两, 线路, 开关管, 消除, 一对, 偏置, 锁相环, 自偏置, NMOS管, 差分线, 差分路径, 毛刺, 自, adaptive, pump, bias+, double, noise, difference, two, glitch, charge, PLL, CP, cancel+

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | CN 109167599 A (CHONGQING UNIVERSITY OF POSTS AND TELECOMMUNICATIONS) 08 January 2019 (2019-01-08) description, paragraphs 2-3, 27-46, figures 1-2 | 1-14 |
| A | CN 102347760 A (ZTE CORPORATION) 08 February 2012 (2012-02-08) entire document | 1-14 |
| A | CN 102075183 A (INSTITUTE OF MICROELECTRONICS OF CHINESE ACADEMY OF SCIENCES) 25 May 2011 (2011-05-25) entire document | 1-14 |
| A | CN 102130681 A (ARKMICRO TECHNOLOGIES INC.) 20 July 2011 (2011-07-20) entire document | 1-14 |
| A | US 8461886 B1 (YAO, Chih-Wei et al.) 11 June 2013 (2013-06-11) entire document | 1-14 |
| A | US 2015200676 A1 (INTERNATIONAL BUSINESS MACHINES CORPORATION) 16 July 2015 (2015-07-16) entire document | 1-14 |

☐ Further documents are listed in the continuation of Box C.　☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **16 January 2020** | **01 February 2020** |

| Name and mailing address of the ISA/CN | Authorized officer |
| --- | --- |
| **China National Intellectual Property Administration (ISA/CN)** **No. 6, Xitucheng Road, Jimenqiao Haidian District, Beijing 100088 China** | |
| Facsimile No. **(86-10)62019451** | Telephone No. |

Form PCT/ISA/210 (second sheet) (January 2015)

INTERNATIONAL SEARCH REPORT
Information on patent family members

International application No.

**PCT/CN2019/088214**

| Patent document cited in search report | | | Publication date (day/month/year) | Patent family member(s) | | | Publication date (day/month/year) |
|---|---|---|---|---|---|---|---|
| CN | 109167599 | A | 08 January 2019 | None | | | |
| CN | 102347760 | A | 08 February 2012 | CN | 102347760 | B | 12 March 2014 |
| CN | 102075183 | A | 25 May 2011 | None | | | |
| CN | 102130681 | A | 20 July 2011 | CN | 102130681 | B | 19 August 2015 |
| US | 8461886 | B1 | 11 June 2013 | US | 8604849 | B1 | 10 December 2013 |
| US | 2015200676 | A1 | 16 July 2015 | US | 2016079989 | A1 | 17 March 2016 |
| | | | | US | 9231605 | B2 | 05 January 2016 |
| | | | | US | 2016094232 | A1 | 31 March 2016 |
| | | | | US | 2015200677 | A1 | 16 July 2015 |
| | | | | US | 9225348 | B2 | 29 December 2015 |
| | | | | US | 9337852 | B2 | 10 May 2016 |
| | | | | US | 9325331 | B2 | 26 April 2016 |

Form PCT/ISA/210 (patent family annex) (January 2015)